# FASCICULE DE BREVET EUROPEEN

(11) **EP 1 111 789 B1**
(45) Date de publication et mention de la délivrance du brevet: **26.11.2008**
(21) Numéro de dépôt: 00403522.6
(22) Date de dépôt: 14.12.2000
(51) Int. Cl.: H03K 17/693

(54) **Organe de commutation électronique à une entrée et plusieurs sorties et son application à une matrice de commutation**
Elektronisches Schaltgerät mit einem Eingang und mehreren Ausgängen und seine Anwendung in einer Schaltmatrix
Electronic switching device with one input and several outputs and its application to a switch matrix

(30) Priorité: 23.12.1999 FR 9916333
(43) Date de publication de la demande: 27.06.2001
(73) Titulaire: Alcatel Lucent, 75008 Paris (FR)
(72) Inventeur: Cayrou, Jean-Christophe, 47000 Agen (FR); Robichez, Sabine, 31400 Toulouse (FR)
(74) Mandataire: Esselin, Sophie

(56) Documents cités:
- EP-A- 0 373 803
- US-A- 5 204 836
- US-A- 5 309 048
- US-A- 5 878 052

## Description

L'invention est relative à un organe de commutation électronique à une entrée et au moins deux sorties ainsi qu'à l'application d'un tel organe à une matrice de commutation reconfigurable.

Pour des applications nécessitant une grande fiabilité, il est courant de prévoir des éléments électroniques redondants de façon que, lorsqu'un élément tombe en panne, il puisse être remplacé par un élément identique. Ce problème se pose notamment dans des applications spatiales.

Pour qu'un élément de secours puisse remplacer l'élément en panne, il est nécessaire de prévoir une commutation qui est commandée soit automatiquement, soit à distance.

Pour cette commutation, on prévoit, en général, une matrice à n entrées et p sorties, le nombre p de sorties étant supérieur au nombre n d'entrées. Chacune des entrées fournit un signal à un élément raccordé à une sortie correspondante. Ainsi, seules n sorties parmi les p disponibles sont normalement actives. Quand l'élément raccordé à une de ces sorties tombe en panne, on effectue une commutation pour que l'entrée correspondante soit reliée à une sortie à laquelle est connecté un élément de remplacement.

Les matrices de commutation utilisées jusqu'à présent font appel à des commutateurs mécaniques. On n'a pas encore réussi à mettre au point une solution de remplacement de type électronique qui offre des avantages comparables à ceux des matrices à commutateurs mécaniques. En effet, ces derniers introduisent des pertes nettement moins importantes que les commutateurs électroniques ; en outre, en l'absence d'alimentation, ils restent dans l'état de commutation qu'ils présentaient avant la panne. Au contraire, les commutateurs électroniques, notamment du domaine des hyperfréquences, sont tels qu'en l'absence d'alimentation, une partie du signal d'entrée est acheminée sur la sortie correcte et une autre partie du signal d'entrée est acheminée sur une autre sortie pour laquelle ce signal n'est pas destiné. Ce dysfonctionnement provoque non seulement des produits d'intermodulation qui sont gênants, mais également des échauffements de filtres. En effet, chaque sortie correspond à une gamme de fréquences et comporte donc un filtre. Si un signal qui ne lui est pas destiné arrive sur une sortie, le filtre associé réfléchit le signal, ce qui provoque l'échauffement.

L'invention concerne donc, selon un premier de ses aspects, un organe de commutation électronique qui minimise les perturbations apportées au fonctionnement d'une matrice de commutation dont il fait partie en cas d'absence d'alimentation de cet organe.

L'organe de commutation électronique, selon l'invention, est destiné à relier une entrée à une parmi plusieurs sorties, et il est caractérisé en ce qu'il comprend :
- pour chaque sortie, une branche de sortie comportant au moins un commutateur électronique dont l'état de conduction est commandé soit pour transférer le signal d'entrée sur la sortie, soit pour réfléchir le signal, et
- une branche de dérivation comportant au moins un commutateur électronique qui dérive le signal d'entrée sur une charge en cas d'absence d'alimentation des commutateurs électroniques de l'organe.

Ainsi, en cas de panne d'alimentation des commutateurs électroniques, le signal d'entrée sera dérivé vers une charge, ce qui protège les éléments qui peuvent être reliés aux sorties tels que des filtres ou des amplificateurs. L'organe de commutation reprend son fonctionnement normal après rétablissement de l'alimentation des commutateurs.

L'invention concerne aussi une matrice de commutation à n entrées et p sorties qui comprend une pluralité de tels organes.

Lors d'une panne d'alimentation des commutateurs de la matrice selon l'invention, les sorties ne sont plus connectées aux entrées correspondantes alors qu'il n'en est pas de même pour une matrice à commutateurs mécaniques. Toutefois, une telle matrice peut avantageusement remplacer une matrice à commutateurs mécaniques car, d'une part, en général, le défaut temporaire de sorties est sans conséquence et, d'autre part, surtout, elle présente l'avantage d'une masse et d'un volume réduits. En outre, son coût peut être sensiblement inférieur.

Dans un mode de réalisation de l'organe de commutation, la branche de dérivation comporte un commutateur électronique disposé en série.

De préférence, dans chaque branche de sortie, on prévoit un commutateur électronique en dérivation qui forme un circuit ouvert lorsque la sortie correspondante est sélectionnée et un court-circuit dans le cas contraire, ou en l'absence d'alimentation.

Pour améliorer le court-circuit, on prévoit, dans chaque branche de sortie, deux commutateurs électroniques en parallèle qui sont commandés par la même polarisation.

Au cours d'essais effectués dans le cadre de l'invention, on a réalisé des commutateurs en technologie MMIC (Monolithic Microwave Integrated Circuit) à deux ou trois sorties présentant des pertes limitées à environ 1,5 décibels.

L'invention se rapporte aussi, selon un autre de ses aspects, à un ensemble d'organes de commutation électroniques susceptible de constituer un module pour une matrice de commutation. Dans un tel ensemble, ou module, chaque entrée est connectable à un nombre r de sorties qui est inférieur au nombre total de sorties.

Dans une réalisation, pour constituer de tels modules on prévoit seulement deux types d'organes de commutation, l'un à deux sorties et l'autre à trois sorties.

Il est préférable que la matrice de commutation soit telle qu'elle comporte des organes de commutation agencés et connectés de façon telle que lorsqu'on commute une entrée connectée à une sortie vers une autre sortie, les pertes dues aux organes de commutation traversés soient les mêmes avant et après la commutation.

Selon un mode de réalisation, les commutateurs électroniques sont des circuits intégrés du domaine des hyperfréquences.

La présente invention prévoit en outre une matrice de commutation comportant une pluralité d'organes de commutation.

Selon un mode de réalisation, la matrice comprend n entrées et p sorties, p étant supérieur à n, chaque entrée étant destinée à être connectée à une parmi r sorties et elle comporte pour chaque entrée, un ensemble d'organes de commutation associés pour présenter une entrée et r sorties.

Selon un mode de réalisation, la matrice comprend, pour chaque sortie, un ensemble d'organes de commutations à r entrées et une sortie, les ensembles associés aux sorties étant montés tête-bêche par rapport aux ensembles associés aux entrées.

Selon un mode de réalisation, les ensembles associés aux sorties ont une structure analogue à la structure des ensembles associés aux entrées.

D'autres caractéristiques et avantages de l'invention apparaîtront avec la description de certains de ses modes de réalisation, celle-ci étant effectuée en se référant aux dessins ci-annexés sur lesquels :
- la figure 1 est un schéma d'organe de commutation conforme à l'invention,
- la figure 2 est un schéma d'une matrice de commutation comprenant une pluralité d'organes de commutation conformes à l'invention,
- la figure 3 représente un ensemble, ou module, d'organes de commutation selon l'invention,
- la figure 4 est une figure analogue à celle de la figure 3, mais pour une variante, et
- la figure 5 représente une matrice de commutation comportant des ensembles d'organes de commutation du type de ceux représentés sur la figure 3.

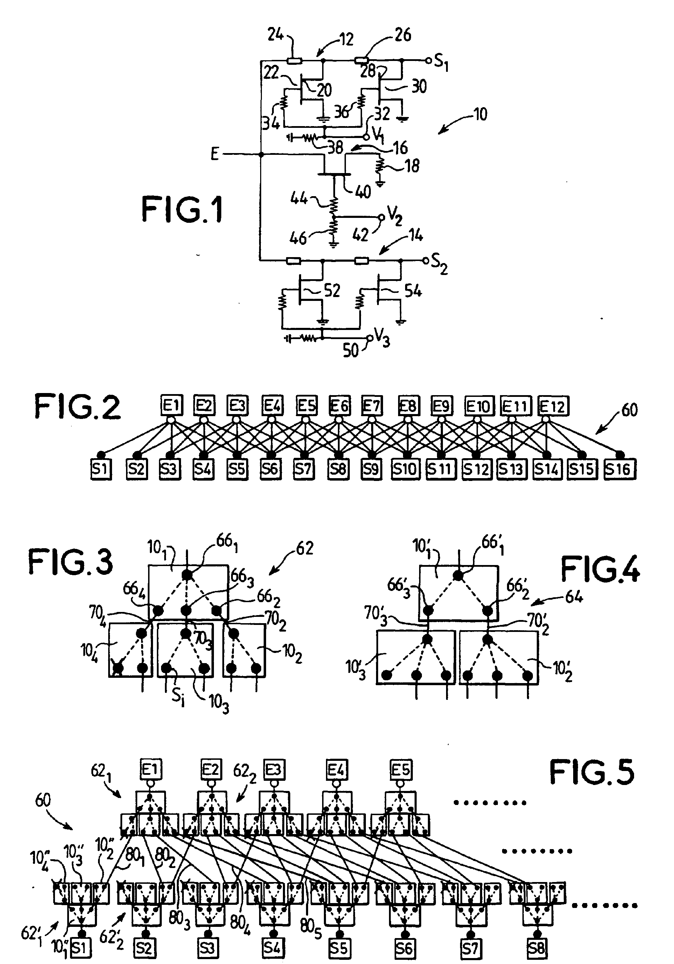

L'organe de commutation 10 représenté sur la figure 1 est un organe de commutation réalisé en technologie MMIC avec un ensemble de transistors fonctionnant en hyperfréquence en technologie intégrée, par exemple sur un substrat en arséniure de gallium.

Dans cet exemple, l'organe de commutation 10 comporte une entrée E et deux sorties S₁ et S₂. Il est cependant possible de réaliser un tel organe de commutation avec des pertes modérées avec trois sorties, comme on le décrira plus loin, notamment avec les figures 3 et 4.

Cet organe de commutation est destiné à transmettre le signal d'entrée E, soit sur la sortie S₁, soit sur la sortie S₂, mais jamais sur deux sorties à la fois. L'organe 10 comporte, tout d'abord, deux branches actives 12 et 14, la branche 12 se terminant par la sortie S₁ et la branche 14 se terminant par la sortie S₂. En outre, l'organe 10 comprend une branche 16 de dérivation permettant de dériver l'entrée E vers une charge 18, de 50 Q par exemple, en cas de panne d'alimentation des commutateurs de l'organe 10.

Dans l'exemple, chacune des branches 12 et 14 comporte deux transistors en dérivation. Ces branches étant identiques, il suffira d'en décrire une seule, à savoir la branche 12.

La borne d'entrée E est reliée au drain 20 d'un transistor 22 par l'intermédiaire d'une ligne 24. La source du transistor 22 est reliée à la masse.

La borne 20 est, par ailleurs, reliée à la sortie S₁ par l'intermédiaire d'une autre ligne de transmission 26.

La borne commune à la ligne 26 et à la sortie S₁ est reliée au drain 28 d'un second transistor 30 dont la source est également connectée à la masse.

Les grilles des deux transistors 22 et 30 sont reliées à une borne 32 de polarisation par l'intermédiaire de résistances, respectivement 34 et 36. Sur cette borne 32 est appliquée une tension continue de polarisation V₁. La borne commune aux résistances 34 et 36 est par ailleurs reliée à la masse par l'intermédiaire d'une résistance 38.

La branche de dérivation 16 comporte un transistor 40 dont la source est connectée à l'entrée E et dont le drain est relié à une extrémité de la résistance de charge 18 dont l'autre extrémité est connectée à la masse. La grille du transistor 40 est reliée à une borne 42 par l'intermédiaire d'une résistance 44. Le point commun à la borne 42 et à la résistance 44 est relié à la masse par l'intermédiaire d'une autre résistance 46.

Sur la borne 42 est appliquée une tension continue de polarisation V₂.

Le fonctionnement est le suivant :

Quand la sortie S₁ est sélectionnée, c'est-à-dire quand l'entrée E doit être transférée sur la sortie S₁, on applique sur la borne 32 une tension V₁ inférieure à la tension de pincement afin que chaque transistor soit équivalent à une résistance pratiquement infinie ; dans l'exemple, cette tension a pour valeur -2 volts. Sur la borne 42 de polarisation du transistor 40 de la branche 16, on applique également une tension de - 2 volts. Enfin, sur la borne 50 de polarisation des transistors de la branche 14, on applique une tension V₃ de 0 volt de façon que le canal du transistor soit ouvert.

Dans ces conditions, les transistors 22 et 30 de la branche 12 constituent des circuits ouverts qui ne perturbent donc pas la transmission du signal vers la sortie S₁.

Par contre, l'application d'une tension de zéro volt sur la borne 50 de la branche 14 met les transistors correspondants 52 et 54 en court-circuit. Il est à noter que, dans le domaine des hyperfréquences, un court-circuit se traduit par le fait que le signal arrivant à la masse est réfléchi vers l'entrée E et est donc renvoyé vers la sortie S₁.

L'application d'une tension de - 2 volts sur la borne 42 de polarisation du transistor 40 de la branche 16 de dérivation maintient ce dernier à l'état ouvert.

En cas de panne d'alimentation, c'est-à-dire quand la (ou les) source(s) de polarisation applique une tension de zéro volt sur les bornes 32, 42 et 50 ou met ces bornes en l'air (c'est-à-dire en circuit ouvert), dans les branches actives 12 et 14, les transistors 22, 30 et 52, 54 sont en court-circuit. Ainsi, ces branches renvoient les signaux vers l'entrée E. Par contre, dans un tel état de panne, le transistor 40 présente une résistance faible et, dans ces conditions, le signal appliqué sur l'entrée E est transféré dans la charge 18. Ainsi, les éléments électroniques, tels que des amplificateurs et/ou des filtres qui sont reliés aux sorties S₁ et S₂ ne reçoivent pas le signal d'entrée. La branche de dérivation 16 constitue donc une protection contre les défauts d'alimentation des commutateurs.

En variante, dans chaque branche active 12 ou 14, on prévoit un seul transistor. Toutefois, on prévoit deux transistors, ou davantage, afin d'améliorer la dérivation vers la masse quand la branche est inactive. En effet, un transistor en court-circuit présente une résistance qui n'est pas nulle et qu'on a intérêt à limiter.

On va maintenant décrire, en relation avec les figures 2 à 5, une matrice de commutation 60 à douze entrées E₁ à E₁₂ et seize sorties S₁ à S₁₆ comportant une pluralité d'organes de commutation du type de celui représenté sur la figure 1.

Chaque entrée est susceptible d'être connectée à cinq sorties. Ainsi, l'entrée E₁ peut être reliée à l'une des sorties S₁, S₂, S₃, S₄ ou S₅. Mais, bien entendu, à chaque fois, l'entrée E₁ n'est connectée qu'à une seule de ces sorties. De même, l'entrée E₂ peut être connectée à l'une des sorties respectivement S₂, S₃, S₄, S₅ et S₆ et ainsi de suite jusqu'à l'entrée E₁₂ qui peut être connectée à l'une des sorties S₁₂, S₁₃, S₁₄ S₁₅ ou S₁₆. De façon plus générale, si la matrice comporte n entrées et p sorties, chaque entrée peut être connectée à p - n + 1 sorties.

Si l'entrée E₁ est connectée à la sortie S₁ et l'entrée E₂ est connectée à la sortie S₄ ; et si l'élément électronique (non montré), relié à la sortie S₁, tombe en panne, il faut pouvoir le remplacer par un élément redondant qui, par exemple, est connecté à la sortie S₂. Dans ces conditions, on commande les organes de commutation de la matrice 60 de façon que l'entrée E₁ ne soit plus reliée à la sortie S₁, mais à la sortie S₂.

Étant donné qu'un organe de commutation de type électronique présente des pertes sensiblement plus élevées qu'un organe de commutation mécanique, il est préférable d'agencer la matrice 60 de façon telle qu'à chaque modification de connexion, il n'y ait pas de modification des pertes. En effet, s'il y avait modification des pertes, il faudrait modifier le gain de l'amplificateur venant en remplacement d'un amplificateur tombé en panne, ce qui compliquerait sensiblement la réalisation du circuit. Un organe électronique apporte un affaiblissement de l'ordre de 1,5 dB, alors que l'affaiblissement correspondant pour un organe de commutation mécanique est de l'ordre de 0,15 dB.

Pour atteindre l'objectif de maintien des pertes en cas de modification de connexion, l'invention prévoit, comme représenté sur les figures 3 et 4, de grouper les organes de commutation en ensembles ou modules 62 (figure 3) ou 64 (figure 4). En outre, à toutes les entrées E₁, E₂, etc. sont associés des ensembles identiques entre eux et à toutes les sorties S₁, S₂, etc. sont associés les mêmes ensembles, comme on le verra plus loin avec l'exemple représenté sur la figure 5.

Les figures 3 et 4 se rapportent au cas où les organes de commutation ne peuvent être que de deux sortes, à savoir une première sorte à une entrée et deux sorties, et une deuxième sorte à une entrée et trois sorties (la sortie de dérivation n'est pas comptée ici). Les ensembles 62 et 64 sont destinés à l'exemple représenté sur la figure 2 ; chacun d'eux comprend donc une entrée et cinq sorties.

L'ensemble 62 (figure 3) comporte, d'une part, un organe de commutation 10₁ à une entrée 66₁ et trois sorties 66₂, 66₃ et 66₄ et, d'autre part, trois organes de commutation 10₂, 10₃ et 10₄ dont chacun comprend une entrée et deux sorties. Étant donné que l'on a besoin seulement de cinq sorties, l'un (10₄) des organes de commutation présente une sortie inactivée. L'entrée de l'organe 10₂ est reliée, par une ligne conductrice 70₂, à la sortie 66₂ de l'organe de commutation 10₁. De façon analogue, l'entrée de l'organe de commutation 10₃ est reliée, par une ligne 70₃, à la sortie 66₃ de l'organe 10₁. Enfin, l'entrée de l'organe 10₄ est reliée à la sortie 66₄ de l'organe 10₁ par une ligne conductrice 70₄.

L'ensemble 64 (figure 4) comporte, d'une part, un organe de commutation 10'₁ à une entrée 66'₁ et deux sorties 66'₂ et 66'₃ et, d'autre part, deux organes de commutation 10'₂ et 10'₃ dont chacun présente une entrée et trois sorties. Étant donné que, comme dans le cas précédent, on a besoin seulement de cinq sorties en tout, l'un des organes de commutation, celui de référence 10'₃, présente une sortie inactivée.

L'entrée de l'organe 10'₂ est reliée à la sortie 66'₂ de l'organe 10'₁ par une ligne conductrice 70'₂ et l'entrée de l'organe 10'₃ est connectée à la sortie 66'₃ de l'organe 10'₁ par l'intermédiaire d'une autre ligne conductrice 70'₃.

Le fonctionnement d'un ensemble 62 ou 64 ressort de sa structure et du fonctionnement de chaque organe de commutation individuel tel qu'il a été décrit en relation avec la figure 1. Par exemple, si l'on veut relier l'entrée 66₁ (figure 3) de l'ensemble 62 à la sortie Si de l'organe 10₃, on commande l'organe 10₁ de façon que l'entrée 66₁ soit reliée à la sortie 66₃ et on commande aussi l'organe 10₃ de façon que son entrée soit reliée à la sortie Sᵢ.

Dans l'exemple représenté sur la figure 5, on prévoit d'affecter un ensemble 62 à chaque borne d'entrée et de sortie. Ainsi, à la borne d'entrée E₁ est affecté l'ensemble 62₁, à la borne d'entrée E₂ est affecté l'ensemble 62₂... à la borne de sortie S₁ est affecté l'ensemble 62'₁, à la borne de sortie S₂ est affecté l'ensemble 62'₂, etc.

Bien entendu, les ensembles 62'₁, 62'₂ etc. sont montés en sens contraire (tête-bêche) des ensembles 62₁, 62₂ etc. De façon plus précise, les organes 10"₂, 10"₃, 10"₄ de l'ensemble 62'₁ comprennent deux entrées et une sortie, et l'organe 10"₁ comporte trois entrées et une sortie.

Enfin, on prévoit des lignes conductrices 80₁, 80₂, 80₃, 80₄, 80₅ reliant chacune des sorties de l'ensemble 62₁ à une entrée des organes 62'₁, 62'₂... 62'₅. En d'autres termes, la ligne 80₁ relie une sortie de l'ensemble 62₁ à une des cinq entrées de l'organe 62'₁, la ligne 80₂ relie la seconde sortie de l'ensemble 62₁ à une des cinq entrées de l'organe 62'₂, etc. On notera qu'une seule des entrées de l'organe 62'₁ est reliée à une ligne conductrice, tandis que les autres ensembles 62'₂, 62'₃, 62'₄, etc. comportent un nombre plus important de lignes conductrices qui aboutissent à leurs entrées.

Quelles que soient les connexions de la matrice, à chaque fois qu'un signal d'une entrée Eᵢ est aiguillé vers une sortie Sᵢ, il traverse les mêmes types d'éléments, à savoir un organe de commutation à une entrée et trois sorties, une ligne conductrice, un organe de commutation à une entrée et deux sorties, une autre ligne conductrice 80ᵢ, un organe de commutation à deux entrées et une sortie, une ligne conductrice et, enfin, un organe de commutation à trois entrées et une sortie. Dans ces conditions, les pertes seront les mêmes quelle que soit la connexion.

Une matrice de commutation équipée d'organes de commutation conformes à l'invention présente un encombrement et une masse nettement plus faibles que l'encombrement et la masse d'une matrice à éléments de commutation de type mécanique, ce qui constitue un avantage décisif dans le cas d'applications spatiales. Enfin, le prix d'une telle matrice peut être plus faible que le prix d'une matrice à organes de commutation mécanique.

## Revendications

1. Organe de commutation (10) à une entrée et au moins deux sorties destiné à transférer sur une seule des sorties un signal appliqué sur l'entrée, **caractérisé en ce qu'**il comprend :
- pour chaque sortie, une branche (12,14) de sortie comportant au moins un commutateur électronique dont l'état de conduction est commandé soit pour transférer le signal d'entrée sur la sortie sélectionnée, soit pour réfléchir le signal, et
- une branche de dérivation (16) comportant au moins un commutateur électronique qui dérive le signal d'entrée sur une charge (18) en cas d'absence d'alimentation des commutateurs électroniques de l'organe.

2. Organe de commutation selon la revendication 1, **caractérisé en ce que** le commutateur électronique (40) de la branche de dérivation est disposé en série.

3. Organe de commutation selon la revendication 1 ou 2, **caractérisé en ce que** le commutateur électronique (20, 30, 52, 54) de chaque branche de sortie est disposé en dérivation.

4. Organe de commutation selon la revendication 3, **caractérisé en ce que** chaque branche de sortie comporte au moins deux commutateurs électroniques (20, 30, 52, 54) en parallèle.

5. Organe de commutation selon l'une quelconque des revendications précédentes, **caractérisé en ce que** chaque commutateur électronique comporte un transistor.

6. Organe de commutation selon l'une quelconque des revendications précédentes, **caractérisé en ce que** les commutateurs électroniques sont des circuits intégrés du domaine des hyperfréquences.

7. Matrice de commutation comportant une pluralité d'organes de commutation selon l'une quelconque des revendications précédentes.

8. Matrice selon la revendication 7, comprenant n entrées et p sorties, p étant supérieur à n, **caractérisée en ce que** chaque entrée étant destinée à être connectée à une parmi r sorties, elle comporte pour chaque entrée un ensemble (62, 64) d'organes de commutation associés pour présenter une entrée et r sorties.

9. Matrice selon la revendication 8, **caractérisée en qu'**elle comprend, pour chaque sortie, un ensemble d'organes de commutations à r entrées et une sortie, les ensembles associés aux sorties étant montés tête-bêche par rapport aux ensembles associés aux entrées.

10. Matrice selon la revendication 9, **caractérisée en ce que** les ensembles associés aux sorties ont une structure analogue à la structure des ensembles associés aux entrées.

## Claims

1. Switching member (10) with one input and at least two outputs and designed to transfer to only one of the outputs a signal applied to the input, **characterized in that** it comprises:
- for each output, an output branch (12, 14) comprising at least one electronic switch whose conduction state is commanded either to transfer the input signal to the selected output, or to reflect the signal, and
- a diversion branch (16) comprising at least one electronic switch which diverts the input signal to a charge (18) in the case of an absence of power supply of the electronic switches of the member.

2. Switching member according to Claim 1, **characterized in that** the electronic switch (40) of the diversion branch is placed in series.

3. Switching member according to Claim 1 or 2, **characterized in that** the electronic switch (20, 30, 52, 54) of each output branch is placed as a diversion.

4. Switching member according to Claim 3, **characterized in that** each output branch comprises at least two electronic switches (20, 30, 52, 54) in parallel.

5. Switching member according to any one of the preceding claims, **characterized in that** each electronic switch comprises a transistor.

6. Switching member according to any one of the preceding claims, **characterized in that** the electronic switches are integrated circuits of the microwave domain.

7. Switching matrix comprising a plurality of switching members according to any one of the preceding claims.

8. Matrix according to Claim 7, comprising n inputs and p outputs, p being greater than n, **characterized in that** each input, being designed to be connected to one out of r outputs, it comprises for each input a set (62, 64) of associated switching members in order to have one input and r outputs.

9. Matrix according to Claim 8, **characterized in that** it comprises, for each output, a set of switching members with r inputs and one output, the sets associated with the outputs being mounted head-to-tail relative to the sets associated with the inputs.

10. Matrix according to Claim 9, **characterized in that** the sets associated with the outputs have a structure similar to the structure of the sets associated with the inputs.

## Patentansprüche

1. Schaltorgan (10) mit einem Eingang und mindestens zwei Ausgängen, das dazu bestimmt ist, an einen einzigen der Ausgänge ein an den Eingang angelegtes Signal zu übertragen, **dadurch gekennzeichnet, dass** es aufweist:
- für jeden Ausgang einen Ausgangsarm (12, 14), der mindestens einen elektronischen Schalter aufweist, dessen Leitzustand entweder zum Übertragen des Eingangssignals an den ausgewählten Ausgang oder zum Reflektieren des Signals gesteuert wird, und
- einen Abzweigarm (16), der mindestens einen elektronischen Schalter aufweist, welcher das Eingangssignal im Fall eines Stromversorgungsausfalls der elektronischen Schalter des Organs an eine Last (18) abzweigt.

2. Schaltorgan nach Anspruch 1, **dadurch gekennzeichnet, dass** der elektronische Schalter (40) des Abzweigarms in Reihe angeordnet ist.

3. Schaltorgan nach Anspruch 1 oder 2, **dadurch gekennzeichnet, dass** der elektronische Schalter (20, 30, 52, 54) jedes Ausgangsarms abgezweigt angeordnet ist.

4. Schaltorgan nach Anspruch 3, **dadurch gekennzeichnet, dass** jeder Ausgangsarm mindestens zwei parallel angeordnete elektronische Schalter (20, 30, 52, 54) aufweist.

5. Schaltorgan nach einem der vorhergehenden Ansprüche, **dadurch gekennzeichnet, dass** jeder elektronische Schalter einen Transistor aufweist.

6. Schaltorgan nach einem der vorhergehenden Ansprüche, **dadurch gekennzeichnet, dass** die elektronischen Schalter integrierte Schaltungen im Hochfrequenzbereich sind.

7. Schaltmatrix, die eine Vielzahl von Schaltorganen nach einem der vorhergehenden Ansprüche aufweist.

8. Matrix nach Anspruch 7, die n Eingänge und p Ausgänge aufweist, wobei p größer ist als n, **dadurch gekennzeichnet, dass** sie, wenn jeder Eingang dazu bestimmt ist, mit einem von r Ausgängen verbunden zu werden, für jeden Eingang eine Gruppe (62, 64) von zugeordneten Schaltorganen aufweist, um einen Eingang und r Ausgänge aufzuweisen.

9. Matrix nach Anspruch 8, **dadurch gekennzeichnet, dass** sie für jeden Ausgang eine Gruppe von Schaltorganen mit r Eingängen und einem Ausgang aufweist, wobei die den Ausgängen zugeordneten Gruppen Kopf bei Fuß bezüglich der den Eingängen zugeordneten Gruppen montiert sind.

10. Matrix nach Anspruch 9, **dadurch gekennzeichnet, dass** die den Ausgängen zugeordneten Gruppen eine Struktur analog zu der Struktur der den Eingängen zugeordneten Gruppen haben.
